# EUROPEAN PATENT APPLICATION

(11) **EP 0 887 938 A1**
(43) Date of publication of application: **30.12.1998**
(21) Application number: 97830304.8
(22) Date of filing: 27.06.1997
(51) Int. Cl.: H03M 1/10

(54) **A/D converter testing structure, particularly for successive approximation A/D converters**

(71) Applicant: STMicroelectronics S.r.l., 20041 Agrate Brianza (Milano) (IT)
(72) Inventor: Brasca, Paolo, 20100 Milano (IT); Casarsa, Marco, 20062 Cassano d'Adda (IT); Pezzini, Saverio, 20059 Vimercate (IT)
(74) Representative: Modiano, Guido, Dr.-Ing.

(57) **Abstract**

An A/D converter testing structure, particularly for successive approximation A/D converters, which comprise an analog part (2) which is interfaced by means of a serial line with a successive approximation register (3), which is in turn interfaced with a digital part (4) which is bidirectionally connected to a data bus (5), the particularity whereof is the fact that it comprises switching means (9) with two inputs (a, b), for the direct loading of the successive approximation register (3) during testing, the switching means (9) being arranged between the analog part (2) and the successive approximation register (3).

## Description

The present invention relates to a converter testing structure, particularly for successive approximation A/D converters.

Successive approximation analog-digital (A/D) converters are characterized by high resolution and by conversion times which are low although greater than those of parallel converters: because of this, they are in widespread use, particularly when the converters must be interfaced with microprocessors.

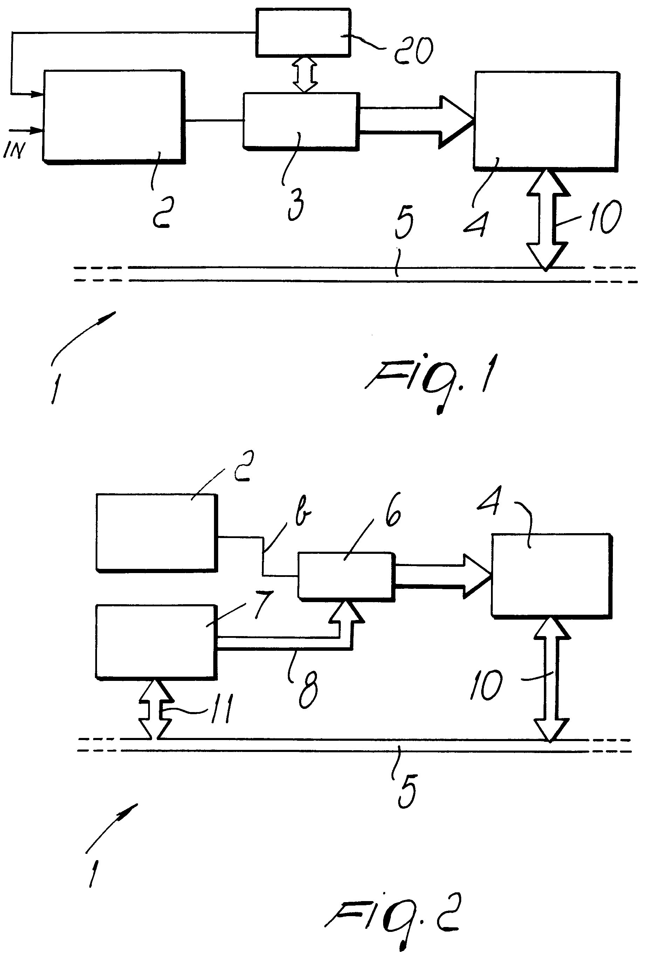

These converters, shown schematically in figure 1 and generally designated by the reference numeral 1, are constituted by a comparator (analog part 2), a successive approximation register 3, referenced to with the acronym SAR, a D/A converter 20, a source for the timing signals of the analog part, and a digital part 4.

In figure 1, the reference numeral 5 designates the internal data bus of the device, which contains the converter 1.

Operation of a successive approximation A/D converter is as follows.

The analog voltage to be converted, Vᵢ, is applied to the comparator. A pulse is applied to the input of the SAR, causing conversion to start. At the first clock pulse, in the successive approximation register SAR the most significant bit is brought to the "1" level, whilst all the other bits remain at zero. The digital output word of the SAR is converted by the D/A converter and the output voltage V' is applied to the comparator, where it is compared with the input voltage Vᵢ.

If V' ≤ Vᵢ, the output of the comparator is high and the value 1 of the bit is confirmed and stored; otherwise, the value 0 is stored. V' > Vᵢ in fact means that the converted output of the SAR provides a voltage which is higher than the input voltage and that therefore the digital word of the SAR is higher than the correct digital value; the value of the bit being considered must therefore be brought to the low level.

At the second clock pulse, the next most significant bit of the SAR is tested: it is brought to the "1" level and this value is maintained or not depending on whether the condition V' ≤ Vᵢ is met.

The method continues until the least significant bit has been considered: the line related to the conversion end signal is then activated in order to indicate that conversion has ended and that therefore the digital data item provided at the output of the SAR is valid. If the converter has n bits (resolution n), the time required for conversion is equal to n clock periods and is therefore much shorter than the conversion time of counter-type or double ramp-type converters.

These converters, and all converters in general, like any other electronic device, must be tested after production and before marketing in order to check their correct operation.

Successive approximation converters are generally tested by checking the operation of the analog part of the converter in close connection to the digital part.

Testing of the digital block of the A/D converter is in fact based on the value generated during conversion by the analog block, and it is therefore necessary to preset the testing equipment so as to generate analog reference voltages.

This testing method entails some drawbacks. First of all, the analog part is affected by an inaccuracy, caused by noise among other factors, which does not allow one to consider the value converted inside the SAR to be deterministic; this makes testing of the digital part of the A/D converter (stimulated by the signals sent by the SAR) scarcely efficient. For example, if one considers by way of example the conversion of the binary value 011111111, the inaccuracy of the analog part of the converter, which is acceptable for that part, might cause the data item 100000000 to be loaded in the SAR. This value differs from the expected one, and during converter testing it could be considered a malfunction of the digital part of the converter although it is actually caused only by the inaccuracy of the analog part.

In this case, therefore, the tested device would be classified as defective and rejected, although the inaccuracy is within the design specifications for the analog part of the converter.

Moreover, for every A/D converter that must be tested it is necessary to set the testing equipment so as to determine the analog values in input which lead to a chosen actual configuration of the SAR.

Due to constructive and process differences, the analog parts of the converters might in fact not all have the same behavior; i.e., an identical analog input signal might not be matched by an identical data item loaded in the SAR.

This entails an increase in testing times.

An aim of the present invention is therefore to provide an A/D converter testing structure, particularly for successive approximation A/D converters, which allows to test the digital part of the converter separately from the analog part, without the influence of the uncertainties introduced by said analog part.

Within the scope of this aim, an object of the present invention is to provide an A/D converter testing structure, particularly for successive approximation A/D converters, which allows to check the signals that arrive from the digital part of the converter, reducing the setup step and the total testing time.

Another object of the present invention is to provide an A/D converter testing structure, particularly for successive approximation A/D converters, which allows to easily check the data item loaded in the successive approximation register.

Another object of the present invention is to provide an A/D converter testing structure, particularly for successive approximation A/D converters, which allows to use programs for automatically generating testing patterns.

Another object of the present invention is to provide an A/D converter testing structure, particularly for successive approximation A/D converters, which is highly reliable and relatively easy to manufacture at competitive costs.

This aim, these objects and others which will become apparent hereinafter are achieved by an A/D converter testing structure, particularly for successive approximation A/D converters, which comprise an analog part which is interfaced by means of a serial line with a successive approximation register, which is in turn interfaced with a digital part which is bidirectionally connected to a data bus, characterized in that it comprises switching means having two inputs, for the direct loading of said successive approximation register during testing, said switching means being arranged between said analog part and said successive approximation register.

Further characteristics and advantages of the invention will become apparent from the description of preferred but not exclusive embodiments of the device according to the invention, illustrated only by way of non-limitative example in the accompanying drawings, wherein:
figure 1 is a block diagram of an architecture of a conventional successive approximation A/D converter;
figure 2 is a block diagram of the architecture of the A/D converter with the testing structure according to a first embodiment of the present invention;
figure 3 is a block diagram of the SAR register, modified for the implementation of the testing structure according to the first embodiment of the invention;
figure 4 is a block diagram of the architecture of the A/D converter with the testing structure according to a second embodiment of the present invention; and
figure 5 is a detailed diagram of the structure of the testing register used in the first embodiment of the present invention.

In all the various figures, identical elements are designated by identical reference numerals.

Figure 1 has already been described and is therefore no longer presented.

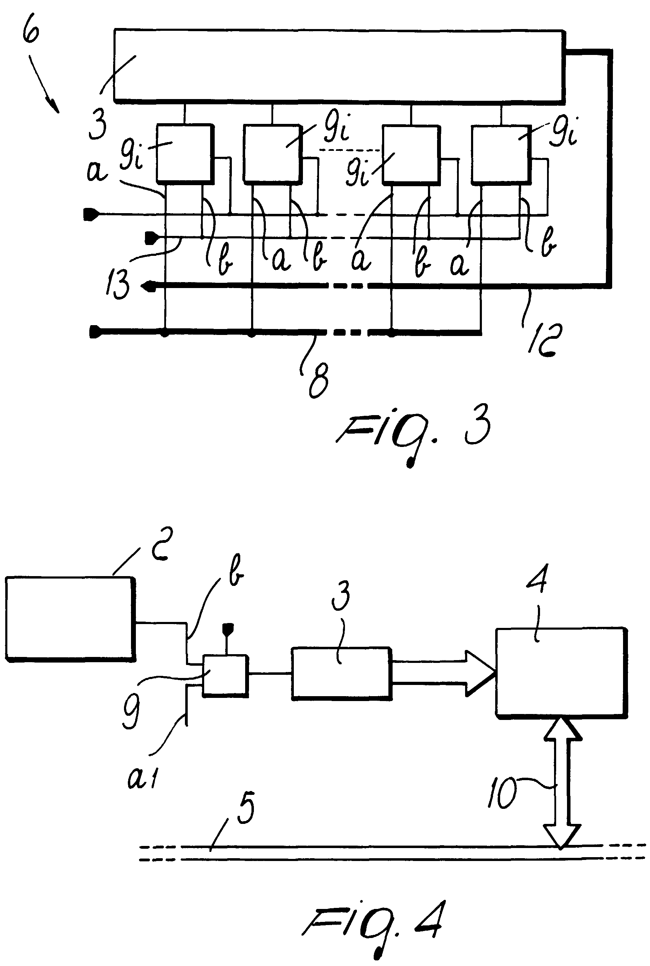

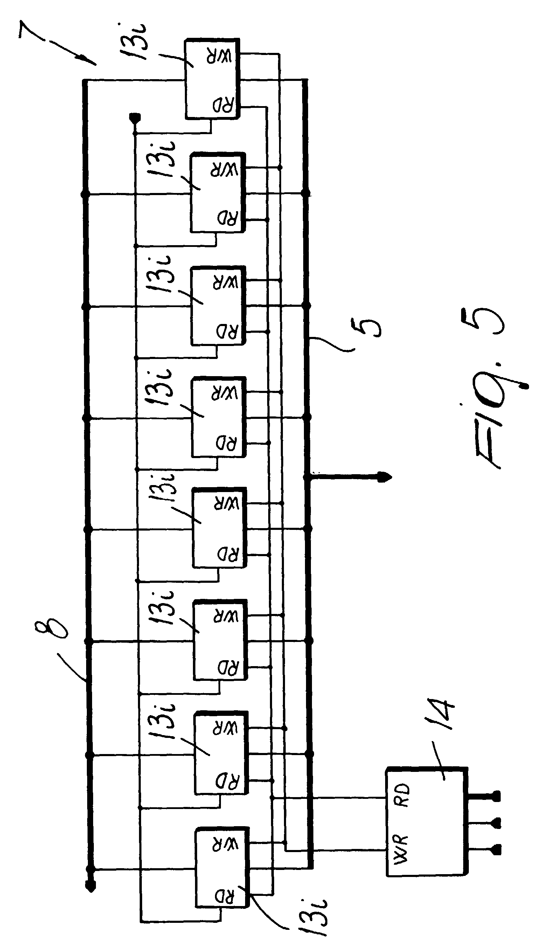

With reference to figures 2, 3 and 5, the successive approximation A/D converter with testing structure comprises, according to a first embodiment and in addition to the analog part 2 and the digital part 4, which are conventional, a programmable register 7 and a SAR register 3 which is modified by adding a plurality of switching means, advantageously constituted by multiplexers 9ᵢ with two inputs a and b. The number of multiplexers is equal to the number of bits of the SAR register 3. The SAR thus modified is shown in figure 3 and designated by the reference numeral 6.

The register 7 is connected, by means of a bus 11, to the data bus 5 of the device in which the A/D converter is inserted, whilst a bus 10 connects the digital part 4 to the data bus 5.

Finally, a bus 8 connects the register 7 to the modified SAR 6.

With reference in particular to figure 3, the multiplexers 9ᵢ respectively receive in input a signal SAR-test for enabling the testing of the SAR register (which is activated only in testing mode), a signal (designated by the reference numeral 13), at the input "b", which indicates the result of the analog comparison performed in the analog part 2 of the A/D converter and, at the input "a", the corresponding bit of the data item loaded in the register 7, which is carried by the bus 8.

The SAR register 3 sends in output, on a line data bus 12, for reading, the value loaded in the SAR by means of the programmable register 7.

A possible embodiment of the programmable register 7 is shown in figure 5. Said register is constituted by a plurality of latches 13ᵢ, one for each bit of the signal to be placed in the register 7; each latch is connected between the data bus and the bus 8 for connecting the register 7 to the modified SAR 6.

Decoder means 14 allow to enable the writing or reading of the latches 13ᵢ: the line WR allows write-enabling, whilst the line RD is the read-enabling line.

The data are thus either written by the data bus 5 in the latches 13ᵢ by means of the connection between the data bus 5 and each latch 13ᵢ or are loaded from each latch 13ᵢ, again on the data bus 5.

The programmable register 7 can be a register dedicated to the testing of the converter or a register which is normally present in the macrocell in which the converter is inserted and usually has a function other than testing.

With reference to figures 2, 3 and 5, operation of the testing structure according to the invention, in its first embodiment, is as follows.

Through the activation signal SAR-test, the multiplexers 9ᵢ are placed in the condition in which the value (data item) that arrives from the analog comparator of the analog part 2, by means of the line 13, is blocked and the data item programmed in the programmable register 7 is loaded in its place in the SAR register 3.

This data item is sent to the SAR 3 by means of the bus 8, passing through the input a of the multiplexers 9ᵢ.

In this manner it is possible to test the digital part 4 of the converter 1 separately from the analog part 2 and without being subjected to influences from it.

The value (data item) programmed in the programmable register 7 and loaded in the SAR 3 instead of the value that arrives from the analog comparator included in the analog part 2, as occurs normally during an ordinary operating step, is in fact assuredly the value that presets the SAR in the intended configuration for allowing to detect its correct operation.

The analog value that arrives from the comparator and is loaded into the SAR would not be able to ensure, as explained earlier, an assuredly correct conversion in the SAR register.

Checking of the state of the SAR register 3 (by means of the line 12) and activation of the testing signal SAR-test can be performed exclusively in the privileged operating mode dedicated to the testing of the device and cannot be selected by the user.

Figure 4 shows a second embodiment of the testing structure according to the invention.

In the previous embodiment, the value that is present in the programmable register 7 is loaded in the multiplexers 9ᵢ in a parallel manner and then loaded into the SAR register 3 serially.

However, the use of a plurality of multiplexers 9ᵢ (whose number is equal to the number of bits provided in the SAR register) entails silicon area occupation and therefore undesirably increases the dimensions of the device (macrocell).

Therefore, in order to reduce silicon area occupation and thus contain the dimensions of the device, the plurality of multiplexers 9ᵢ is replaced, in the second embodiment, with a single multiplexer 9 with two inputs a1 and b, in which the input b, as in the previous case, receives the result of the analog comparison performed in the analog part 2, whilst the input a1 is a serial input which allows the passage, through the multiplexer 9, of all the bits of a test signal which is generated by a testing logic unit and is meant to be loaded into the SAR 3.

In this case, too, the multiplexer is selected by the SAR-test signal, which is activated only in the testing mode.

The input a1 of the multiplexer 9, driven by means of the testing logic unit, can be connected to a primary input pin of the device or to the output of a circuit dedicated to testing.

In practice it has been observed that the testing structure according to the invention fully achieves the intended aim and objects, since it allows to test the digital part separately from the analog part without the uncertainty introduced by said analog part, with the additional advantage of reducing the testing time and of allowing the use of programs for automatically generating the test patterns (Automatic Test Pattern Generator - ATPG - programs).

The testing structure thus conceived is susceptible of numerous modifications and variations, all of which are within the scope of the inventive concept; all the details may furthermore be replaced with other technically equivalent elements.

In practice, the materials employed, so long as they are compatible with the specific use, as well as the dimensions, may be any according to requirements and to the state of the art.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. An A/D converter testing structure, particularly for successive approximation A/D converters, which comprise an analog part which is interfaced by means of a serial line with a successive approximation register, which is in turn interfaced with a digital part which is bidirectionally connected to a data bus, characterized in that it comprises switching means with two inputs, for the direct loading of said successive approximation register during testing, said switching means being arranged between said analog part and said successive approximation register.

2. An A/D converter testing structure, particularly for successive approximation A/D converters according to claim 1, characterized in that said switching means comprise a single multiplexer, a first input whereof is connected to a serial line which arrives from said analog part of the converter and a second input whereof is a serial input connected to a testing logic unit.

3. An A/D converter testing structure, particularly for successive approximation A/D converters according to claim 2, characterized in that said multiplexer is selected by a signal for enabling the testing mode, said enabling signal inhibiting the transfer of data from said analog part to said successive approximation register, across said multiplexer, and enabling the transfer of data from said testing logic unit.

4. An A/D converter testing structure, particularly for successive approximation A/D converters according to claim 1, characterized in that said switching means comprise a plurality of multiplexers, whose number is equal to the number of bits of said successive approximation register, and a programmable register connected to said multiplexers.

5. An A/D converter testing structure, particularly for successive approximation A/D converters according to claim 4, characterized in that said programmable register is connected to said multiplexers by means of a bus.

6. An A/D converter testing structure, particularly for successive approximation A/D converters according to claim 5, characterized in that said multiplexers have a first input which is connected to a serial line of said analog part and a second input which is connected to said programmable register by means of said bus.

7. An A/D converter testing structure, particularly for successive approximation A/D converters according to claim 1, characterized in that said successive approximation register is provided with a line for external reading of the data contained in said successive approximation register.

8. An A/D converter testing structure, particularly for successive approximation A/D converters according to claim 4, characterized in that said multiplexers are selected by a signal for enabling the testing mode.

9. An A/D converter testing structure, particularly for successive approximation A/D converters according to claim 4, characterized in that said programmable register is constituted by a plurality of latch circuits selected by decoder means, for writing in and reading from said latch circuits.

10. An A/D converter testing structure, particularly for successive approximation A/D converters according to claim 4, characterized in that said programmable register is connected to a data bus of the device in which said converter is present.

11. A method for testing A/D converters, particularly successive approximation A/D converters, by means of a testing structure according to claim 1, characterized in that it comprises the steps of:
loading, in said testing mode, by means of said switching means, a chosen value in said successive approximation register, blocking the connection of said register to the analog part of said converter; and
analyzing the behavior of said successive approximation register and of the devices driven thereby.

12. A method according to claim 11, characterized in that it further comprises a step for selecting said switching means for enabling said testing mode.

13. A method according to claim 11, characterized by the step of loading a value in a programmable register which is connected to said switching means, said switching means being constituted by a plurality of multiplexers with two inputs.

14. A method according to claim 11, characterized in that said switching means comprise a single multiplexer with two inputs.

15. A method according to claim 13, characterized in that an input of said multiplexers is connected to said programmable register and a second input is connected to said analog part.

16. A method according to claim 14, characterized in that an input of said single multiplexer is connected to said analog part and a second input thereof is a serial input which is dedicated to the testing step.
